Europäisches Patentamt

European Patent Office

Office européen des brevets

(19)

(11) Publication number: **0 202 061 B1**

# (12) EUROPEAN PATENT SPECIFICATION

(45) Date of publication of patent specification: **24.04.91**

(51) Int. Cl.⁵: **G01R 31/28, G01R 27/28**

(21) Application number: **86303402.1**

(22) Date of filing: **06.05.86**

(54) **Test machinery.**

(30) Priority: **14.05.85 GB 8512124**

(43) Date of publication of application:
**20.11.86 Bulletin 86/47**

(45) Publication of the grant of the patent:
**24.04.91 Bulletin 91/17**

(84) Designated Contracting States:
**AT DE FR GB IT NL SE**

(56) References cited:
**DE-A- 2 311 991**
**US-A- 3 663 954**
**US-A- 3 833 856**

**THE MICROWAVE JOURNAL, vol. 15, 22nd September 1972, pages 42, 44, US; J.M. CARSLEY et al.: "The versatile vector voltmeter"**

(73) Proprietor: **FERGUSON LIMITED**
**Thorn Emi House Upper Saint Martin's Lane London, WC2H 9ED(GB)**

(72) Inventor: **Randall, Philip**
**125, Cozens Road**
**Ware Hertfordshire(GB)**

(74) Representative: **Einsel, Robert, Dipl.-Ing.**
**Deutsche Thomson-Brandt GmbH Patent- und Lizenzabteilung Göttinger Chaussee 76 W-3000 Hannover 91(DE)**

## Description

The present invention relates to test machinery for testing electrical circuits, or parts thereof.

US 3833856 (Roeschlein) discloses a testing device for measuring phase shift and amplitude changes in an amplifier. The testing device comprises a frequency synthesizer which provides a sine wave at a desired frequency through first and second channels with the amplifier being connected in the first channel. The outputs from the first and second channels are applied to a computer for analysis. The computer is programmed to calculate the phase angles for the waveforms. The difference in these phase angles is the phase shift of the amplifier under test and this difference is presented in a readout device.

An article 'The Versatile Voltmeter' in 'The Microwave Journal' Vol. 15, 22nd September 1972 (J.M. Carsley et al) discloses means to measure the transit time of a signal through a device by measuring the change in phase shift at each of a number of frequencies. A signal generator produces a signal at a single frequency. This is supplied to a power divider having one input port and two output ports. One output port is connected directly to a first input port of a sampling head and the other output port is connected to a second input port of the sampling head via the device under investigation. The sampling head is connected to a vector voltmeter which produces a measurement of amplitude and phase to give the phase shift produced by the device at the single frequency. The signal generator frequency is varied in small increments and the change in phase shift is noted at each increment.

The present invention provides a test machinery comprising a testing station, the testing station having:
means to apply a signal of a predetermined frequency to a test location;
and means to process the signal applied to a test location together with the signal output from the test location, in order to provide simultaneously a measurement of the signal amplitude of at least one of the signals and an indication of the phase-relationships of the signals; characterised in that:
the test machinery comprises more than one testing station, each testing station being arranged to provide a respective predetermined frequency, specific to that testing station, for enabling, with contemporaneous operation of more than one testing station, the output of the signal processing means of any operating testing station to indicate an electrical connection between the test location of said any testing station and the test location of another operating testing station.

By comparing, for each station, the detected amplitude and phase-relationship with those values known to be correct for the type of unit under test, an immediate analysis as to the existence of faults (and their nature) can be made. The comparison and/or analysis can be done by an operator, or can be done at least partially by appropriate electronic equipment.

In particular the machinery can be used to diagnose cross-connections between units being tested as well as, inter alia, the following: faulty operation of a unit itself; faulty electrical connections within the unit itself; faulty electrical connections interfacing with the unit.

Preferably, the signal processing means comprises means to produce a composite signal with amplitude and phase characteristics in accordance with (i) the signal applied to a test location and (ii) the signal output from the test location, and the test machinery further comprises means to provide a display representing the output of said means to produce a composite signal.

Preferably each said predetermined frequency is within a predetermined range such that superposition of signals associated with a first and a second testing station creates a detectable beat frequency. Accordingly, the occurrence of a beat frequency in a signal output from a station indicates that there is crossed electrical connections between stations in the machinery; moreover, by measuring the beat frequency, the identity of the other station involved can be determined.

In one preferred form of the present invention the signal processing means is a solid-state device arranged to form an output signal which is proportional to one of the signals input to it, namely the signal output from a test location; for example, it may be a Field Effect Transistor driven by the output signal from the test location and gated by the input signal to the test location, the resultant signal passing on to the display means.

Thus the output is proportional to the signal from the unit under test only; the f.e.t. acts as a synchronous switch i.e. as a phase detector.

In another preferred form, the signal processing means is a solid-state device arranged to form an output signal which is proportional to both of the signals input to it, namely the signal input to a test location and the resultant signal output from that test location.

Another aspect of the present invention provides a method of testing an electrical circuit, or a part thereof, positioned at a test location within a testing station, the method comprising the steps of:
applying a signal of a predetermined frequency to a test location;
and processing the signal applied to the test location together with the signal output from the test location in order to provide simultaneously a measurement of the signal amplitude of at least one of the signals and an indication of the phase-relationships of the signals; characteristed in that the method is simultaneously applied at more than one test location using a respective predetermined frequency specific to that test location and testing station whereby the output of the signal processing means of any testing station can indicate an electrical correction between the test location of said any testing station and the test location of another testing station.

The present invention is particularly suited to the testing of circuit boards which have the parallel arrangement of major components (for example video amplifiers for selective colour processing); the present invention enables the simultaneous testing of all the video amplifiers on a circuit board, checking them for faulty operation and for cross-connections.

In order that the invention may more readily be understood, a description is now given, by way of example only, reference being made to the accompanying drawings, in which:

Figure 1 is a schematic diagram of test machinery embodying the present invention;
Figure 2 is a circuit diagram of part of the test machinery of Figure 1; and
Figure 3 is a schematic diagram of another form of test machinery embodying the present invention.

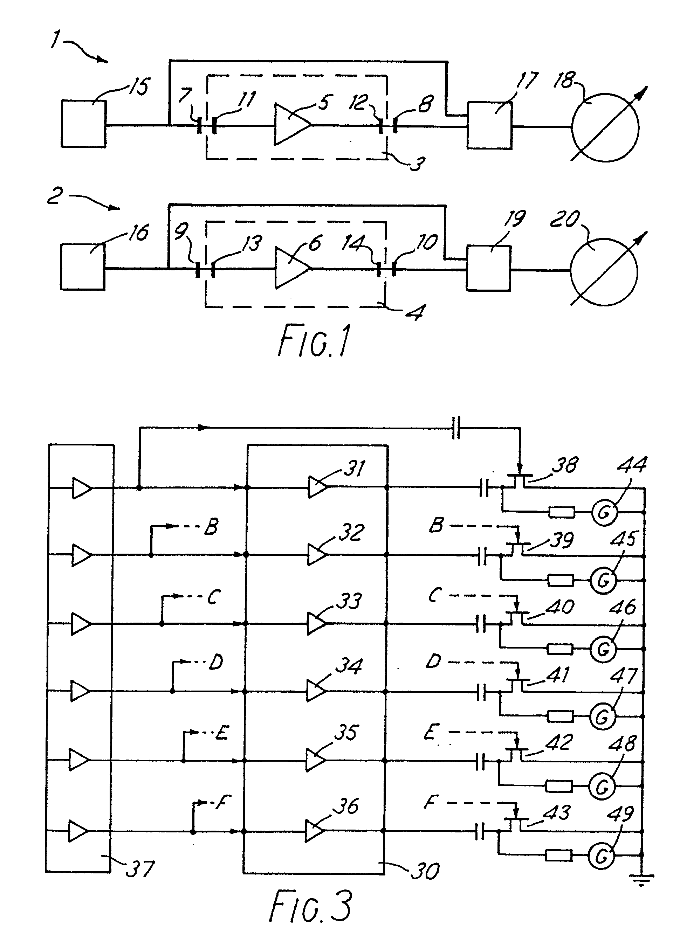

Figure 1 show schematically a simplified form of test machinery having two testing stations 1 and 2 each of which has a test location 3 and 4 respectively at which components 5, 6 (incorporating their associated leads) are placed for testing, suitable electrical connection being made between terminals 7, 8 (or 9, 10) of a station and the lead terminals 11, 12 (or 13, 14). Each station has an oscillator 15, 16 respectively, which produces an alternating square-wave signal of a predetermined frequency which is unique, in the machine, to that station.

Considering firstly the station 1, the signal from oscillator 15 has a frequency of X Herz and is passed both to terminal 7 of test location 3 and to a gate of a field-effect transister 17. The signal output from test location 3 via terminal 8 is passed to an input of f.e.t.17. Thus f.e.t.17 is gated by one signal and driven by the other to produce an output signal which is dependent on the condition of the signal emerging from the test location; this output signal is passed to a moving-coil galvanometer 18 which measures the means value of current relating to the output signal. The condition and value of the current measured by galvanometer 18 provides a number of clues as to the identity of whatever is connected between terminals 7 and 8 at the testing location.

Thus if a video amplifier (of known rating) and its associated leads is connected in correct fashion between terminals 7 and 8, f.e.t. 17 is gated and driven by two input signals of identical phase but differing amplitude. Hence the signal output from f.e.t. 17 has a frequency of X Herz in phase with the oscillator output and with an amplitude related to the input drive signal which emerged from the test location, so that the galvanometer provides a constant reading. By noting whether the value measured by galvanometer 18 lies within acceptable tolerance of the correct reading for that type of amplifier, operation of the particular component 5 is readily and quickly tested. If the galvanometer reading is outside acceptable tolerance of the correct reading, then the deviation from this correct value can be determined and used to adjust the functioning of amplifier 5 until it operates correctly; for example by analysing the deviation together with the responsive characteristics of f.e.t. 17, the required change in output of amplifier 5 can be determined so that its gain control characteristics can be suitably altered.

A null reading at galvanometer 18 (after checking the terminal 7 to 11 connection and terminal 8 to 13 connection) may indicate a fault either within amplifier 5 itself or within its leads.

Testing station 2 operates in similar fashion to station 1 except that oscillator 16 produces a signal of frequency Y Herz differing from that of oscillator 15 but being within 5% of the latter; otherwise, the f.e.t. 19, the galvanometer 20 and their arrangement are indentical to the counterparts in station 1.

A reading at either of the galvanometers which is approximately half the correct value indicates that there is a short-circuit of two signals, i.e. that the signal being input to the f.e.t. is derived from two separate sources each with an individual frequency.

A reading at either of the galvanometers which varies periodically between particular minimum and maximum values indicates cross-connection in some manner between the circuits.

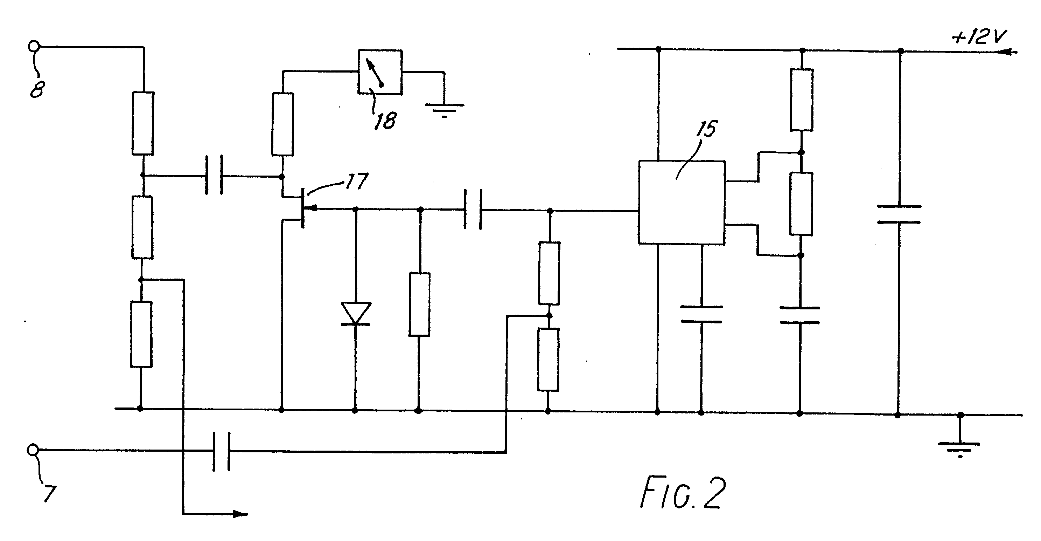

Figure 2 is a circuit diagram of the elements which constitute testing station 1 of the test machinery shown schematically in Figure 1.

Figure 3 shows schematically part of another form of test machine for the testing of samples of a section of circuitry on a circuit board 30. The circuitry for testing has a number of video amplifiers 31 to 36 each with associated leads. The machine has a hex Schmitt trigger integrated circuit device 37 which constitutes six independent square-wave oscillators, each feeding a different, predetermined frequency both to one of the amplifiers on board 30 and to one of the f.e.t. devices 38 to 43 working as a phase detector. By appropriate monitoring of galvanometers 44 to 47 in accordance with the techniques described with reference to Figures 1 and 2, the condition of operation of amplifiers 31 to 36 and the connections of their respective leads can be determined readily and quickly; moreover, any faults can be identified easily, and their location can be found quickly.

## Claims

1. Test machinery comprising a testing station, the testing station having:
   means to apply a signal of a predetermined frequency to a test location;
   and means to process the signal applied to a test location together with the signal output from the test location, in order to provide simultaneously a measurement of the signal amplitude of at least one of the signals and an indication of the phase-relationships of the signals; characterised in that:
   the test machinery comprises more than one testing station, each testing station being arranged to provide a respective predetermined frequency, specific to that testing station, for enabling, with contemporaneous operation of more than one testing station, the output of the signal processing means of any operating testing station to indicate an electrical connection between the test location of said any testing station and the test location of another operating testing station.

2. Test machinery according to Claim 1 characterised in that the signal processing means comprises means to produce a composite signal with amplitude and phase characteristics in accordance with (i) the signal applied to a test location and (ii) the signal output from the test location, and in that the test machinery further comprises means to provide a display representing the output of said means to produce a composite signal.

3. Test machinery according to Claim 1 or Claim 2, characterised in that each predetermined frequency is within a predetermined range such that superposition of signals associated with a first and a second testing station creates a detectable beat frequency.

4. Test machinery according to any one of the preceding claims characterised in that the machinery further comprises means for measuring beat frequencies, if produced.

5. Test machinery according to any one of the preceding claims, characterised in that the signal processing means is a solid-state device arranged to form an output signal which is proportional to at least one of the signals input to it.

6. Test machinery according to Claim 5 characterised in that the solid state device is arranged to form an output signal which is proportional to the signal output from a test location.

7. Test machinery according to Claim 5 characterised in that the solid-state device is arranged to form an output signal which is proportional to both of the signals input to it.

8. A method of testing an electrical circuit, or a part thereof, positioned at a test location within a testing station, the method comprising the steps of:
   applying a signal of a predetermined frequency to a test location;
   and processing the signal applied to the test location together with the signal output from the test location in order to provide simultaneously a measurement of the signal amplitude of at least one of the signals and an indication of the phase-relationships of the signals; characterised in that the method is simultaneously applied at more than one test location using a respective predetermined frequency specific to that test location and testing station whereby the output of the signal processing means of any testing station can indicate an electrical connection between the test location of said any testing station and the test location of another testing station.

9. A method according to Claim 8, characterised in that the processing step comprises the step of producing, for each test location, a composite signal with amplitude and phase characteristics in accordance with (i) the signal applied to the test location and (ii) the signal output from the test location; and in that the method further comprises the step of providing, for each testing station, a display representing a form of the composite signal.

10. A method according to Claim 8 or Claim 9, characterised in that each said predetermined frequency is within a predetermined range such that superposition of signals associated with a first and a second testing station creates a detectable beat frequency.

11. A method according to any one of Claims 8 to 10, characterised in that the method further comprises the step of measuring any beat frequency, whereby the identity of said another testing station can be determined.

**Revendications**

1. Outillage d'essai comprenant une station d'essai, la station d'essai ayant :
   - des moyens pour appliquer un signal d'une fréquence prédéterminée à un emplacement d' essai ;
   - et des moyens pour traiter le signal appliqué à un emplacement d'essai avec le signal sorti provenant de l'emplacement d'essai pour fournir simultanément une mesure de l'amplitude du signal d'au moins un des signaux et une indication des rapports de phases des signaux, caractérisé en ce que l'outillage d'essai comprend plus d'une station d'essai, chaque station d'essai étant disposée pour fournir une fréquence prédéterminée respective spécifique à cette station d'essai pour permettre, avec le fonctionnement simultané de plus d'une station d'essai, la sortie des moyens de traitement de signaux d'une station d'essai quelconque fonctionnant pour indiquer une connexion électrique entre l'emplacement d'essai de la station d'essai quelconque citée et l'emplacement d'essai d'une autre station d'essai fonctionnant.

2. Outillage d'essai selon la revendication 1, caractérisé en ce que les moyens de traitement de signaux comprennent des moyens pour produire un signal vidéo-composite avec des caractéristiques d'amplitude et de phases en conformité avec (i) le signal appliqué à un emplacement d'essai et (ii) le signal sorti provenant de l'emplacement d'essai et que l'outillage d'essai comprend, en plus, des moyens pour créer une visualisation représentant la sortie des moyens cités pour produire un signal vidéo-composite.

3. Outillage d'essai selon la revendication 1 ou 2, caractérisé en ce que chaque fréquence prédéterminée se trouve dans une gamme prédéterminée telle que la superposition des signaux associés à une première et à une seconde station d'essai crée une fréquence de battement qui peut être détectée.

4. Outillage d'essai selon l'une quelconque des revendications précédentes, caractérisé en ce que l'outillage comprend en plus des moyens pour mesurer les fréquences de battement, s'il y en a de produites.

5. Outillage d'essai selon l'une quelconque des revendications précédentes, caractérisé en ce que les moyens de traitement des signaux consistent en un composant monolithique disposé pour former un signal de sortie qui est proportionnel à au moins l'un des signaux qui y sont introduits.

6. Outillage d'essai selon la revendication 5, caractérisé en ce que le composant monolithique est disposé pour former un signal de sortie qui est proportionnel au signal sorti provenant d'un emplacement d'essai.

7. Outillage d'essai selon la revendication 5, caractérisé en ce que le composant monolithique est disposé pour former un signal de sortie qui est proportionnel aux deux signaux qui y sont introduits.

8. Méthode d'essai d'un circuit électrique, ou d'une partie d'un circuit, placé à un emplacement d'essai à l'intérieur d'une station d'essai, la méthode comprenant les pas :
   - d'application d'un signal d'une fréquence prédéterminée à un emplacement d'essai ;
   - et de traitement du signal appliqué à l'emplacement d'essai avec le signal sorti de l'emplacement d'essai pour fournir simultanément une mesure de l'amplitude du signal d'au moins l'un des signaux et une indication du rapport de phases des signaux, caractérisée en ce que la méthode est appliquée simultanément à plus d'un emplacement d'essai en utilisant une fréquence prédéterminée respective spécifique à cet emplacement d'essai et à cette station d'essai, la sortie des moyens de traitement de signaux d'une station d'essai quelconque pouvant indiquer une connexion électrique entre l'emplacement d'essai de la station d'essai quelconque citée et l'emplacement d'essai d'une autre station d'essai.

9. Méthode selon la revendication 8, caractérisée en ce que le pas de traitement comprend le pas de production, pour chaque emplacement d'essai, d'un signal vidéo-composite avec des caractéristiques d'amplitude et de phases en conformité avec (i) le signal appliqué à un emplacement d'essai et (ii) le signal sorti provenant de l'emplacement d'essai et en ce que la méthode comprend en plus le pas de création, pour chaque station d'essai, d'une visualisation représentant une forme du signal vidéocomposite.

10. Méthode selon la revendication 8 ou 9, caractérisée en ce que chaque fréquence prédéterminée se trouve à l'intérieur d'une gamme prédéterminée telle que la superposition de signaux associés à une première station d'essai et à une seconde station d'essai crée une fréquence de battement qui peut être détectée.

11. Méthode selon l'une quelconque des revendications 8 - 10, caractérisé en ce que la méthode de plus comprends un pas dans lequel une eventuelle fréquence superhétérodyne est mesurée par quel moyen l'identité de l'autre station d'essai mentionné peut être déterminé.

**Ansprüche**

1. Prüfmaschinerie mit einer Prüfstation, welche das folgende aufweist:
Mittel zum Anlegen eines Signals einer vorbestimmten Frequenz an eine Prüfstelle;
und Mittel zum Verarbeiten des der Prüfstelle zugeführten Signals gemeinsam mit dem von der Prüfstelle ausgegebenen Signal, um gleichzeitig eine Messung der Signalamplitude wenigstens eines der Signale und eine Angabe der Phasenverhältnisse der Signals zu erlauben; dadurch gekennzeichnet, daß:
die Prüfmaschinerie mehr als eine Prüfstation umfaßt, wobei jede Prüfstation so ausgebildet ist, daß sie eine jeweils vorgegebene Frequenz erzeugt, welche für die jeweilige Prüfstation spezifisch ist, um es zu ermöglichen, daß - bei gleichzeitigem Betrieb von mehr als einer Prüfstation - die Ausgabe der signalverarbeitenden Mittel irgendeiner Prüfstation eine elektrische Verbindung zwischen der Prüfstelle der genannten irgendeiner Prüfstation und der Prüfstelle einer anderen in Betrieb befindlichen Prüfstation angezeigt wird.

2. Prüfmaschinerie nach Anspruch 1, dadurch gekennzeichnet, daß die Signalverarbeitungsmittel Mittel zum Erzeugen eines Mischsignals mit Amplituden- und Phaseneigenschaften enstprechend (i) dem einer Prüfstelle zugeführten Signal und (ii) dem von der Prüfstelle ausgegebenen Signal aufweisen und daß die Prüfmaschinerie weiterhin Mittel aufweist, die eine Anzeige liefern, welche das Ausgangssignal der Mittel zur Erzeugung eines Mischsignals darstellen.

3. Prüfmaschinerie nach Anspruch 1 oder Anspruch 2, dadurch gekennzeichnet, daß jede der vorgegebenen Frequenzen innerhalb eines vorgegebenen Bereichs liegt, derart, daß eine Überlagerung von einer ersten und einer zweiten Prüfstation zugehörigen Signalen eine feststellbare Überlagerungsfrequenz erzeugt.

4. Prüfmaschinerie nach einem der vorgenannten Ansprüche, dadurch gekennzeichnet, daß die Maschinerie weiterhin Mittel zum Messen von eventuell erzeugten Überlagerungsfrequenzen aufweist.

5. Prüfmaschinerie nach einem der vorgenannten Ansprüche, dadurch gekennzeichnet, daß die Signalverarbeitungsmittel aus einem Festkörperbauteil (Solid-State Device) bestehen, welches so ausgebildet ist, daß es ein Ausgangssignal bildet, welches zu wenigstens einem der ihm zugeführten Signale proportional ist.

6. Prüfmaschinerie nach Anspruch 5, dadurch gekennzeichnet, daß das Festkörperbauteil so ausgebildet ist, daß es ein Ausgangssignal bildet, welches zu dem von einer Prüfstelle ausgegebenen Signal proportional ist.

7. Prüfmaschinerie nach Anspruch 5 dadurch gekennzeichnet, daß das Festkörperbauteil so ausgebildet ist, daß es ein Ausgangssignal bildet, welchen zu beiden ihm zugeführten Signalen proportional ist.

8. Verfahren zum Prüfen eines elektrischen Schaltkreises oder eines Teiles davon, welches(r) an einer Prüfstelle innerhalb einer Prüfstation angeordnet ist, wobei das Verfahren die folgenden Schritte umfaßt:
ein Signal von vorbestimmter Frequenz wird einer Prüfstelle zugeführt;
und das der Prüfstelle zugeführte Signal wird zusammen mit dem von der Prüfstelle ausgegebenen Signal verarbeitet, um gleichzeitig eine Messung der Signalamplitude wenigstens eines der beiden Signale und eine Angabe der Phasenverhältnisse der Signale zu erlangen; dies ist dadurch gekennzeichnet, daß das Verfahren gleichzeitig an mehr als einer Prüfstelle angewandt wird, wobei eine jeweilige vorbestimmte Frequenz verwandt wird, die für diese Prüfstelle und Prüfstation spezifisch ist, wobei das Ausgangssignal der Signalverarbeitungsmittel irgendeiner Prüfstation eine elektrische Verbindung zwischen der Prüfstelle der genannten irgendeinen Prüfstelle und der Prüfstelle einer anderen Prüfstation anzeigen kann.

9. Verfahren nach Anspruch 8, dadurch gekennzeichnet, daß der Verarbeitungsschritt einen Schritt umfaßt, in dem für jede Prüfstelle ein Mischsignal mit Amplituden- und Phaseneigenschaften enstprechend (i) dem der Prüfstelle zugeführten Signal und (ii) dem von der Prüfstelle ausgegebenen Signal erzeugt wird, und daß das Verfahren weiterhin einen Schritt aufweist, in dem für jede Prüfstation eine eine Form des Mischsignals darstellende Anzeige erzeugt wird.

10. Verfahren nach Anspruch 8 oder Anspruch 9, dadurch gekennzeichnet, daß jede der vorgegebenen Frequenzen innerhalb eines vorgegebenen Bereichs liegt, derart, daß eine Überlagerung von einer ersten und einer zweiten Prüfstation zugehörigen Signalen eine feststellbare Überlagerungsfrequenz erzeugt.

11. Verfahren nach einem der Ansprüche 8 - 10, dadurch gekennzeichnet, daß das Verfahren weiterhin einen Schritt umfaßt, in dem eine etwaige Überlagerungsfrequenz gemessen wird, wodurch die Identität der genannten anderen Prüfstation ermittelt werden kann.

FIG.1

FIG.3

FIG. 2

+12V

EP 0 202 061 B1